(19) Europäisches Patentamt

European Patent Office

Office européen des brevets

(11) **EP 1 282 011 B1**

(12) **EUROPÄISCHE PATENTSCHRIFT**

(45) Veröffentlichungstag und Bekanntmachung des Hinweises auf die Patenterteilung:
**22.11.2006 Patentblatt 2006/47**

(51) Int Cl.:
*G03F 7/20* (2006.01)　　*G02B 17/06* (2006.01)

(21) Anmeldenummer: **02016693.0**

(22) Anmeldetag: **26.07.2002**

(54) **Reflektives Projektionsobjektiv für EUV-Photolithographie**

Reflective projection lens for EUV photolithography

Lentille de projection réflective pour la photolithographie dans l'ultraviolet extrême

(84) Benannte Vertragsstaaten:
**DE FR GB NL**

(30) Priorität: **01.08.2001 US 308861 P**

(43) Veröffentlichungstag der Anmeldung:
**05.02.2003 Patentblatt 2003/06**

(73) Patentinhaber: **Carl Zeiss SMT AG**
**73446 Oberkochen (DE)**

(72) Erfinder:
- **Mann, Hans-Jürgen**
  **73447 Oberkochen (DE)**
- **Ulrich, Wilhelm**
  **73434 Aalen (DE)**
- **Hudyma, Russel M.**
  **San Ramon, CA 94583 (US)**

(74) Vertreter: **Muschik, Thomas**
**Patentanwälte Ruff, Wilhelm,**
**Beier, Dauster & Partner,**
**Kronenstrasse 30**
**70174 Stuttgart (DE)**

(56) Entgegenhaltungen:
**US-A- 5 222 112　　US-A- 5 911 858**

- **STEARNS D G ET AL: "MULTILAYER MIRROR TECHNOLOGY FOR SOFT-X-RAY PROJECTION LITHOGRAPHY" 1. Dezember 1993 (1993-12-01), APPLIED OPTICS, OPTICAL SOCIETY OF AMERICA,WASHINGTON, US, PAGE(S) 6952-6960 , XP000414602 ISSN: 0003-6935 Section 4. Graded Multilayer Coatings**

**Beschreibung**

Die Erfindung betrifft ein Projektionsobjektiv zur Abbildung eines in einer Objektebene angeordneten Musters in eine Bildebene mit Hilfe von elektromagnetischer Strahlung aus dem extremen Ultraviolettbereich (EUV).

Projektionsobjektive dieser Art werden in Projektionsbelichtungsanlagen zur Herstellung von Halbleiterbauelementen und anderen feinstrukturierten Bauteilen verwendet. Sie dienen dazu, Muster von Photomasken oder Strichplatten, die nachfolgend allgemein als Masken oder Retikel bezeichnet werden, auf einen mit einer lichtempfindlichen Schicht beschichteten Gegenstand mit höchster Auflösung zu projizieren.

Um immer feinere Strukturen erzeugen zu können, werden verschiedene Wege verfolgt, das Auflösungsvermögen der Projektionsobjektive zu erhöhen. Bekanntlich kann das Auflösungsvermögen dadurch erhöht werden, dass die bildseitige numerische Apertur (NA) des Projektionsobjektives vergrößert wird. Eine andere Maßnahme ist es, mit immer kürzeren Wellenlängen der verwendeten elektromagnetische Strahlung zu arbeiten.

Die Verbesserung der Auflösung durch Steigerung der numerischen Apertur hat einige Nachteile. Der größte Nachteil besteht darin, dass mit steigender numerischer Apertur die erzielbare Schärfentiefe (depth of focus, DOF) abnimmt. Dies ist nachteilig, weil beispielsweise aus Gründen der erzielbaren Ebenheit der zu strukturierenden Substrate und mechanischer Toleranzen eine Schärfentiefe in der Größenordnung von mindestens einem Mikrometer wünschenswert ist. Daher wurden Systeme entwickelt, die bei moderaten numerischen Aperturen arbeiten und die Vergrößerung des Auflösungsvermögens im wesentlichen durch die kurze Wellenlänge der verwendeten elektromagnetischen Strahlung aus dem extremen Ultraviolettbereich (EUV) erzielen. Bei der EUV-Lithographie mit Arbeitswellenlänge von 13,4nm kann beispielsweise bei numerischen Aperturen von NA=0,1 theoretisch eine Auflösung in der Größenordnung von 0,1$\mu$m bei typischen Schärfentiefen in der Größenordnung von ca. 1$\mu$m erreicht werden.

Strahlung aus dem extrem Ultraviolettbereich kann bekanntlich nicht mehr mit Hilfe refraktiver optischer Elemente fokussiert werden, da die kurzen Wellenlängen von den bekannten, bei höheren Wellenlängen transparenten optischen Materialien absorbiert werden. Daher werden für die EUV-Lithographie Spiegelsysteme eingesetzt, bei denen zwischen der Objektebene und der Bildebene mehrere mit Reflexbeschichtungen versehene, abbildende, d.h. konkave oder konvexe Spiegel angeordnet sind, die eine optische Achse des Projektionsobjektivs definieren. Die verwendeten Reflexbeschichtungen sind typischerweise Mehrlagenbeschichtungen, beispielsweise mit Molybdän/Silizium-Wechselschichten.

Ein Spiegelobjektiv für die EUV-Lithographie mit vier Spiegeln, die jeweils Reflexbeschichtungen mit gleichmäßiger Schichtdicke aufweisen, ist in der US 5,973,826 offenbart.

Ein anderes EUV-Lithographiesystem ist in der US 5,153,898 gezeigt. Das System hat maximal fünf Spiegel, von denen mindestens eine eine asphärische Spiegelfläche aufweist. Es sind zahlreiche Materialkombinationen für EUV- geeignete Mehrlagen-Reflexbeschichtungen angegeben. Die Schichten haben jeweils gleichmäßige Schichtdicken.

Reflexbeschichtungen konstanter Dicke sind zwar relativ einfach herstellbar, erzeugen jedoch in der Regel bei Abbildungssystemen, bei denen der Einfallswinkel oder Inzidenzwinkel der verwendeten Strahlung auf die Spiegelfläche stark über den genutzten Spiegelbereich variiert, große Reflexionsverluste, da die Schichtdicke nur für einen speziell gewählten Einfallswinkel bzw. einen engen Einfallswinkelbereich optimal arbeitet. Ein weiterer Nachteil ist eine mangelhafte Pupillenhomogenität, die zu einem Telezentriefehler, strukturabhängiger oder feldabhängiger Auflösungsgrenze (sogenannte H-V-Differenzen oder CD-Variationen) und generell zu einer Verkleinerung des Prozessfensters führt.

Es sind auch abbildende EUV-Spiegelsysteme bekannt, bei denen Spiegel mit gradierten Reflexbeschichtungen vorgesehen sind, die sich dadurch auszeichnen, dass sie einen zur optischen Achse des Gesamtsystemes rotationssymmetrischen Schichtdickenverlauf aufweisen (US 5,911,858). Mit Hilfe gradierter Reflexbeschichtungen kann eine bessere Gleichverteilung der reflektierten Intensität über einen gewissen Inzidenzwinkelbereich erzielt werden.

Photolithographiegeräte oder Stepper verwenden zwei unterschiedliche Methoden der Projektion einer Maske auf ein Substrat, nämlich das "Step-and-repeat" und das "Step-and-Scan"-Verfahren. Beim "Step-and-repeat"-Verfahren werden nacheinander größere Substratbereiche mit jeweils dem gesamten auf einem Retikel vorhandenen Muster belichtet. Entsprechende Projektionsoptiken haben daher ein Bildfeld, das groß genug ist, um die gesamte Maske auf das Substrat abzubilden. Nach jeder Belichtung wird das Substrat verfahren und der Belichtungsprozess wiederholt. Dagegen wird beim hier bevorzugten Step-and-Scan-Verfahren das Maskenmuster durch einen beweglichen Schlitz auf das Substrat gescannt, wobei sich Maske und Substrat synchron im Verhältnis des Abbildungsmaßstabes des Projektionsobjektives gegeneinander in der Scan-Richtung bewegen.

Der Erfindung liegt die Aufgabe zugrunde, ein mit hoher numerischer Apertur betreibbares EUV-Projektionsobjektiv bereitzustellen, das bei ausreichender Abbildungsqualität eine gute Korrektur von Verzeichnungsfehlern in allen Bildrichtungen und eine hinreichend symmetrische Ausleuchtung des Bildfeldes mit hoher Beleuchtungsintensität ermöglicht. Insbesondere soll ein Projektionsobjektiv geschaffen werden, welches unter optischen Gesichtspunkten einen sinnvollen Kompromiss zwischen Wellenfrontfehler, Verzeichnung, Gesamttransmission, Felduniformität und Pupillenhomogenität darstellt.

Diese Aufgabe wird gelöst durch ein Projektionsobjektiv gemäß Anspruch 1 zur Abbildung eines in einer Objektebene angeordneten Musters in eine Bildebene mit Hilfe von elektromagnetischer Strahlung aus dem extremen Ultraviolettbereich (EUV), wobei zwischen der Objektebene und der Bildebene mehrere mit Reflexbeschichtungen versehene, abbildende Spiegel angeordnet sind, die eine optische Achse des Projektionsobjektives definieren, wobei mindestens einer der Spiegel eine dezentrierte, gradierte Reflexbeschichtung mit einem zu einer Beschichtungsachse rotationssymmetrische Schichtdickenverlauf aufweist, bei der die Beschichtungsachse exzentrisch zur optischen Achse des Projektionsobjektives angeordnet ist.

Die bei der Erfindung vorgesehene Dezentrierung einer gradierten, rotationssymmetrischen Reflexbeschichtung in Bezug auf die optische Achse des gesamten Abbildungssystemes schafft einen bei herkömmlichen Systemen nicht vorhandenen, zusätzlichen Freiheitsgrad für die Optimierung der optischen Eigenschaften des Projektionsobjektivs. Hierbei ist zu berücksichtigen, dass das Design bzw. die optische Auslegung eines EUV-Projektionssystemes sich grob in zwei aufeinanderfolgende Schritte unterteilen lässt. Zunächst werden die Anordnung und die Gestaltung der unbeschichteten Spiegelsubstrate unter Berücksichtigung der klassischen Kriterien (z.B. Wellenfrontaberrationen, Verzeichnung, Baubedingungen, Fertigungsbedingungen etc.) rechnerisch mit Hilfe geeigneter Design-Software optimiert. Anschließend werden die Reflexbeschichtungen berechnet und das Design wird unter Berücksichtigung der Reflexbeschichtungen neu durchgerechnet. Die Schichten werden sozusagen auf die unbeschichteten Substrate "gelegt". Hierdurch ergibt sich im allgemeinen eine deutliche Verschlechterung der vom unbeschichteten System erreichten Abbildungsqualität, die in der Regel nicht ohne eine anschließende Reoptimierung des Systems toleriert werden kann.

Bei der Reoptimierung sind unter anderem die durch die Reflexbeschichtungen hervorgerufenen Wellenfrontaberrationen und Wellenfrontapodisierungen zu berücksichtigen. Konkurrierende Effekte sind dabei vor allem die Gesamttransmission des Systems einerseits und die Felduniformität andererseits. Es wurde herausgefunden, dass diese wichtigen Eigenschaften in der Regel durch die zur Verfügung stehenden Änderungsmöglichkeiten am Design gegenläufig beeinflusst werden. Gute Kompromisslösungen, die hinreichende Gesamttransmission bei ausreichender Felduniformität liefern, können mit Hilfe dezentrierter, rotationssymmetrischer Reflexbeschichtungen besonders günstig erreicht werden. Dabei hat sich allgemein gezeigt, dass die Bereitstellung von dezentrierten, gradierten Reflexbeschichtungen besonders für die Gesamttransmission förderlich ist. Die Felduniformität bevorzugt dagegen Reflexbeschichtungen, die zur optischen Achse zentriert sind.

Als Ausgangspunkt für die Reoptimierung dienen in der Regel Winkelbelastungsrechnungen für die einzelnen Spiegelflächen. Aus diesen können insbesondere die tatsächlich genutzten Bereiche (foot prints) eines jeden Spiegels, die durchschnittlichen Einfallswinkel in jedem Punkt jedes Spiegels und die Winkelbandbreiten bzw. Inzidenzwinkelbereiche in jedem Punkt eines Spiegels abgeleitet werden. Von diesen Daten sind besonders die durchschnittlichen Einfallswinkel und der Inzidenzwinkelbereich (Winkelbandbreite) von Bedeutung.

Da Beschichtungen für die EUV-Systeme in erster Linie dazu dienen sollen, die auftreffende elektromagnetische Strahlung so stark wie möglich zu reflektieren, kann das Design in Richtung maximaler Reflektivität optimiert werden. Hierzu können die aus Winkelbelastungsberechnungen erhältlichen mittleren Einfallswinkel für jeden Punkt herangezogen und zur Grundlage der Berechnung der für die Reflektivität optimalen Schichtdicken herangezogen werden. Der Verlauf wird wesentlich durch die Form des Objektfeldes mitbestimmt, das bei bevorzugten Ausführungsformen ein Ringfeldsegment ist.

Es hat sich gezeigt, dass es vorteilhaft ist, wenn zumindest der Spiegel mit dem größten Inzidenzwinkelbereich, d.h. der größten Winkelbandbreite, eine dezentrierte, gradierte Reflexbeschichtung aufweist. Dem liegt die Erkenntnis zugrunde, dass konstante Schichtdicken bei Systemen, bei denen der Einfallswinkel stark über den Spiegelbereich variiert, einen enormen Verlust an Reflexionsgrad bringen, da Schichten konstanter Dicke nur für einen speziell gewählten Einfallswinkel bzw. einen engen Einfallswinkelbereich optimiert werden können. Dieses Problem tritt insbesondere bei hochaperturigen Systemen (z.B. bei Systemen mit NA >0,2) auf, da die Einfallswinkel auf den Spiegeln maßgeblich durch die Apertur bestimmt sind. Wird derjenige Spiegel identifiziert, bei dem der größte Inzidenzwinkelbereich auftritt, so können durch Designmaßnahmen, wie eine Dezentrierung einer rotationssymmetrischen Reflexbeschichtung, besonders wirksame Eingriffe in die Abbildungseigenschaften des Systems vorgenommen werden.

Bei einer bevorzugten Ausführungsform reicht der Inzidenzwinkelbereich des Spiegels mit größtem Inzidenzwinkelbereich bis zu Winkeln unterhalb von 5 bis 10° und oberhalb von 10 oder 15°. Der Inzidenzwinkelbereich kann beispielsweise von ca. 1° bis ca. 17° reichen.

Wenn ein Spiegelsystem auf besonders hohe Gesamttransmissionen optimiert werden soll und gegebenenfalls die Felduniformität eine untergeordnete Rolle spielt, so kann es vorteilhaft sein, wenn zumindest der Spiegel mit dem größten Inzidenzwinkelbereich eine dezentrierte, gradierte Reflexbeschichtung aufweist. Deren Schichtdickenverlauf in Radialrichtung kann so optimiert werden, dass sich im gesamten Inzidenzwinkelbereich ein hoher Reflexionsgrad für die verwendete Strahlung einstellt. Allerdings kann es bei einer komplexen Optimierungsaufgabe so sein, dass die Verwendung von reflexoptimierten Schichten das System so weit von einem ursprünglich erreichten lokalen Minimum der Optimierung entfernt, das eine automatische Auffindung dieses Minimums nicht mehr möglich ist. Dadurch besteht die Gefahr, dass statt einer Reoptimierung eines Designs ein demgegenüber neues Design entsteht.

Da eine einzige dezentrierte, gradierte Reflexbeschichtung innerhalb eines Spiegelsystems neben den erwünschten positiven Wirkungen gegebenenfalls auch negative Einflüsse auf die Abbildungsqualität haben kann, ist in bevorzugten Ausführungsformen ein Spiegel mit einer ersten dezentrierten gradierten Reflexbeschichtung und mindestens ein anderer Spiegel mit einer zweiten, dezentrierten gradierten Reflexbeschichtung vorgesehen, wobei die erste und die zweite dezentrierte gradierte Reflexbeschichtung derart in Bezug auf Dezentrierung, Schichtdickenverlauf etc. aufeinander abgestimmt sind, dass sich Beiträge der Reflexbeschichtungen zu bestimmten Bildfehlern mindestens teilweise kompensieren. Hier ist insbesondere die Verzeichnung in Cross-Scan-Richtung (x-Richtung) kritisch, da für diese Art der Verzeichnung kein Kompensationseffekt durch den in der senkrecht dazu verlaufenden y-Richtung verlaufenden Scanvorgang existiert. Bei bevorzugten Ausführungsformen ist die Dezentrierung der Reflexbeschichtung daher so gestaltet, dass die Beschichtungsachse relativ zur optischen Achse des Projektionsobjektives in einer y-Richtung dezentriert ist, welche bei einem Scanner der Scanrichtung entspricht.

Es hat sich als vorteilhaft herausgestellt, wenn die Schichtdicke d des rotationssymmetrischen Schichtdickenverlaufes folgender Form entspricht:

$$d = d_0 \sum_{i=0}^{n} c_{2i} (r - r_0)^{2i} \qquad\qquad (1)$$

genügt. Dabei bezeichnet $d_0$ die für senkrechten Strahlungseinfall (Inzidenzwinkel = $0^0$) optimierte Schichtdicke, $r_0$ beschreibt die Dezentrierung der Beschichtungsachse in der x-y-Ebene gegenüber der optischen Achse des Systems und r beschreibt die aktuelle Koordinate in der x-y-Ebene. Die Parameter c sind Polynomenkoeffizienten. Der bevorzugte Schichtdickenverlauf ist also durch ein quadratisches Polynom ohne ungerade, insbesondere ohne lineare Terme beschreibbar und kann in einem einfachen Fall beispielsweise parabelförmig sein.

Ein im Zusammenhang mit einem Ausführungsbeispiel näher erläutertes, bevorzugtes Projektionsobjektiv hat zwischen Objektebene und Bildebene sechs Spiegel. Der fünfte, auf die Objektebene folgende Spiegel ist derjenige Spiegel, bei dem der größte Inzidenzwinkelbereich auftritt. Dieser Spiegel kann bei einem reflexoptimierten System eine zentrierte, gradierte Reflexionsschicht haben. Bei anderen Varianten sind bei mehreren Spiegeln zentrierte, gradierte Reflexbeschichtungen vorgesehen, die so aufeinander abgestimmt sind, dass die Pupillenhomogenität im wesentlichen rotationssymmetrisch ist. Bevorzugt sind zwei, maximal vier solcher Spiegel, da laterale Schichtdickenverläufe fertigungstechnisch aufwendig sind. Für eine gleichzeitige Optimierung mehrerer Qualitativkriterien, insbesondere der Gesamttransmission und der Verzeichnung, ist zumindest an diesem fünften Spiegel eine dezentrierte, gradierte Reflexionsschicht vorgesehen.

Besonders günstige Ergebnisse werden erzielt, wenn mindestens einer der dem fünften Spiegel vorgeschalteten Spiegel, beispielsweise der dritte oder der vierte Spiegel, ebenfalls eine dezentrierte, gradierte Reflexbeschichtung aufweist, wobei die Rotationsachsen der beiden Schichtverläufe der aufeinanderfolgenden, gradierten Reflexionsschichten parallel zur optischen Achse derart dezentriert werden, dass sich die jeweiligen Beiträge zur Verzeichnung in Cross-Scan-Richtung gegenseitig wenigstens teilweise gegenseitig kompensieren.

Die vorstehenden und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können. Es zeigen:

Fig. 1   eine schematische Längsschnittdarstellung einer Ausführungsform eines EUV-Projektionsobjektivs mit sechs abbildenden Spiegeln,

Fig. 2   eine schematische Darstellung einer Transmissionsverteilung in der Austrittspupille des Projektionsobjektivs für einen Feldpunkt auf der Symmetrieachse bei Verwendung von Reflexschichten mit konstanter Schichtdicke auf allen Spiegeln,

Fig. 3   eine entsprechende Transmissionsverteilung in der Austrittspupille für einen Feldpunkt am Rande des Ringfeldes;

Fig. 4   ein schematische Diagramm der Transmissionsverteilung über das Bildfeld bei Verwendung von Reflexbeschichtungen mit konstanter Schichtdicke,

Fig. 5   eine schematische Darstellung einer Transmissionsverteilung in der Austrittspupille für einen Feldpunkt auf der Symmetrieachse bei einem Projektionsobjektiv, welches auf einem Spiegel eine dezentrierte, gradierte Reflexbeschichtung aufweist,

Fig. 6      eine entsprechende Transmissionsverteilung in der Austrittspupille für einen Feldpunkt am Rande des Ringfeldes,

Fig. 7      ein schematisches Diagramm einer Transmissionsverteilung über das Bildfeld bei Verwendung einer dezentrierten, gradierten Reflexbeschichtung,

Fig. 8      eine schematische Darstellung der Transmissionsverteilung in der Austrittspupille für einen Feldpunkt auf der Symmetrieachse bei einem Projektionsobjektiv mit einer zentrierten, gradierten Reflexbeschichtung auf einem der Spiegel,

Fig. 9      eine entsprechende Transmissionsverteilung in der Austrittspupille für einen Feldpunkt am Rande des Ringfeldes,

Fig. 10      ein schematisches Diagramm einer Transmissionsverteilung

Fig. 11      über das Bildfeld bei einem Projektionsobjektiv mit einer zentrierten, gradierten Reflexionsbeschichtung auf einem der Spiegel, eine schematische Darstellung der Transmissionsverteilung in

Fig. 12      der Austrittspupille für einen Feldpunkt auf der Symmetrieachse bei einem Projektionsobjektiv, bei welchen auf zwei Spiegeln zentrierte, gradierte Reflexbeschichtungen vorgesehen sind, die zur Erzielung einer im wesentlichen rotationssymmetrischen Pupillenhomogenität auf einander abgestimmt sind, eine entsprechende Transmissionsverteilung in der

Fig. 13      Austrittspupille für einen Feldpunkt am Rande des Ringfeldes, ein schematisches Diagramm einer Transmissionsverteilung

Fig. 14      über das Bildfeld bei einem Projektionsobjektiv mit zentrierten, gradierten Reflexionsbeschichtungen auf zwei Spiegeln, ein schematisches Diagramm einer Transmissionsverteilung in der Austrittspupille für einen Feldpunkt auf der Symmetrieachse bei einem Projektionsobjektiv, bei dem an zwei Spiegeln jeweils eine dezentrierte, gradierte Reflexbeschichtung angebracht ist, wobei die Dezentrierung der Reflexbeschichtungen zur gegenseitigen Kompensation von Verzeichnungsbeiträgen aneinander angepasst sind,

Fig. 15      eine entsprechende Transmissionsverteilung in der Austrittspupille für einen Feldpunkt am Rande des Ringfeldes, und

Fig. 16      ein schematisches Diagramm einer Transmissionsverteilung über das Bildfeld für ein Projektionsobjektiv, bei dem an zwei Spiegeln dezentrierte, gradierte Reflektionsbeschichtungen zur gegenseitigen Kompensation und von Verzeichnungsbeiträgen angeordnet sind.

Bei der folgenden Beschreibung wesentlicher der Erfindung Zugrundeliegender Prinzipien bezeichnet der Begriff "optischer Achse" eine gerade Linie oder eine Folge von geraden Linienabschnitten durch die paraxialen Krümmungsmittelpunkte der optischen Komponenten, bei denen es sich bei den beschriebenen Ausführungsformen ausschließlich um Spiegel mit gekrümmten Spiegelflächen handelt. Das Objekt ist in den Beispielen eine Maske (Retikel) mit dem Muster einer integrierten Schaltung, es kann sich aber auch um ein anderes Muster, beispielsweise eines Gitters, handeln. Das Bild wird in den Beispielen auf einem als Substrat dienenden, mit einer Photoresistschicht versehenen Wafer gebildet, jedoch sind auch andere Substrate, beispielsweise Elemente für Flüssigkeitskristallanzeigen oder Substrate für optische Gitter möglich.

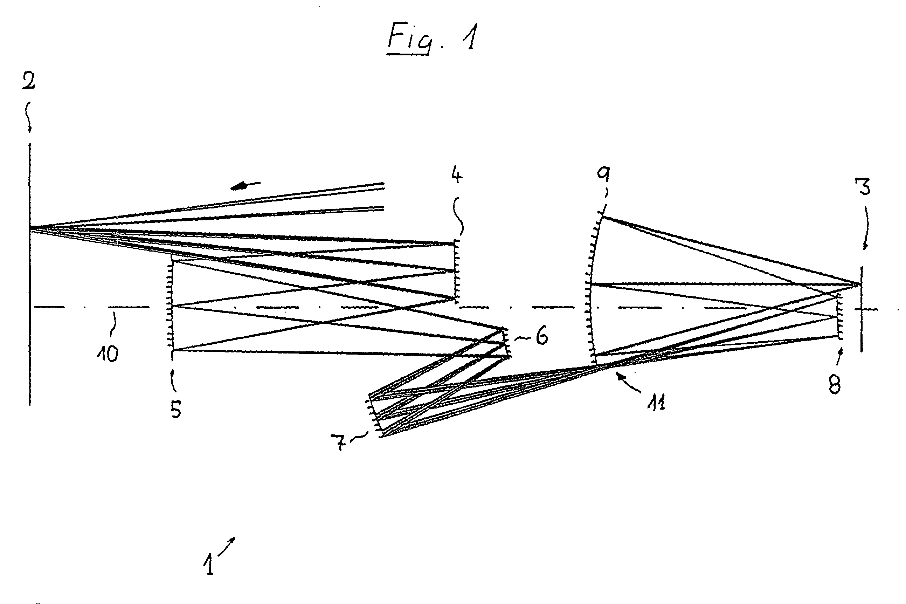

Ein typischer Aufbau eines EUV-Projektionsobjektivs 1 ist anhand eines bevorzugten Ausführungsbeispiels in Fig. 1 gezeigt. Es dient dazu, ein in einer Objektebene 2 angeordnetes Muster eines Retikels oder dergleichen in eine parallel zu Objektebene ausgerichtete Bildebene 3 in reduziertem Maßstab abzubilden, beispielsweise im Verhältnis 4: 1. Die Abbildung erfolgt mittels elektromagnetischer Strahlung aus dem extremen Ultraviolettbereich (EUV), insbesondere bei einer Arbeitswellenlänge von ca. 13,4μm. Zwischen der Objektebene 2 und der Bildebene 3 sind insgesamt sechs mit gekrümmten Spiegelflächen versehene und dadurch abbildende Spiegel 4 bis 9 derart koaxial zueinander angeordnet, dass sie eine gemeinsame optische Achse 10 definieren, die senkrecht auf der Bildebene und der Objektebene steht. Die Spiegelsubstrate 4 bis 9 haben die Form rotationssymmetrischer Asphären, deren Symmetrieachse mit der gemeinsamen mechanischen Achse 10 zusammenfällt. Das für einen Step-and-Scan-Betrieb konzipierte Sechs-Spiegel-System arbeitet mit einem Off-Axis-Ringfeld, erreicht eine numerische Apertur NA=0,25 bei einer typischen Feldgröße von 2 x 26mm$^2$.

Wie in Fig. 1 erkennbar, trifft das Licht aus einem (nicht gezeigten) Beleuchtungssystem, welches eine Lichtquelle für weiche Röntgenstrahlung umfasst, von der bildzugewandten Seite der Objektebene 2 zunächst die in der Objektebene 2 angeordnete reflektive Maske. Das reflektierte Licht trifft auf einen ersten Spiegel 4, der eine objektwärts gerichtete, konkave Spiegelfläche hat, welche die auftreffende Strahlung leicht verengt auf einen zweiten Spiegel 5 reflektiert. Der zweite Spiegel 5 hat eine dem ersten Spiegel 4 zugewandte konkave Spiegelfläche, die die Strahlung in Richtung eines dritten Spiegels 6 als konvergentes Strahlbündel reflektiert. Der dritte Spiegel 6 hat eine konvexe Spiegelfläche, die die außeraxial auftreffende Strahlung in Richtung einer konkaven Spiegelfläche eines vierten Spiegels 7 reflektiert. Dieser wird in einem Spiegelbereich weit außerhalb der optischen Achse genutzt und reflektiert die auftreffende Strahlung unter Bildung eines reellen Zwischenbildes 11 auf einen in der Nähe der Bildebene 3 angeordneten fünften Spiegel 8. Dieser hat eine von der Bildebene abgewandte konvexe Spiegelfläche, welche die auftreffende divergente Strahlung in Richtung eines sechsten Spiegels 9 reflektiert, welcher eine zur Bildebene 3 gewandte, konkave Spiegelfläche aufweist, mit der die auftreffende Strahlung reflektiert und auf die Bildebene 3 fokussiert wird.

Alle reflektierenden Flächen der Spiegel 4 bis 9 sind mit reflexionserhöhenden Reflexbeschichtungen belegt. Bei bevorzugten Ausführungsformen handelt es sich um Schichtstapel von beispielsweise ca. vierzig Wechselschichtpaaren, wobei ein Wechselschichtpaar jeweils eine Siliziumschicht und eine Molybdänschicht umfasst.

In Tabelle 1 ist die Spezifikation des dargestellten Design in tabellarischer Form zusammengefasst. Dabei gibt Zeile 1 die Nummer bzw. die Bezeichnung der reflektierenden oder auf andere Weise ausgezeichneten Flächen, Zeile 2 den Radius der Flächen (in Millimeter) und Zeile 3 den Abstand der jeweiligen Fläche zur nachfolgenden Fläche (in Millimeter) an. Die Vorzeichen der Radien sind so gewählt, dass ein positives Vorzeichen einem auf der Seite der Bildebene liegenden Krümmungsmittelpunkt der Spiegelfläche entspricht. Die mit A bis E bezeichneten Zeilen 4 bis 9 geben die Asphärenkoeffizienten der asphärischen Spiegelflächen an. Es ist erkennbar, dass sämtliche Spiegelflächen asphärisch gekrümmt sind. Die asphärischen Flächen können nach folgender Vorschrift berechnet werden:

$$p(h)=[((1/r)h^2)/(1+SQRT(1-(1+K)(1/r)^2h^2))]+A*h^4+B*h^6+....$$

Dabei gibt der Kehrwert (1/r) des Radius die Flächenkrümmung und h den Abstand eines Flächenpunktes von der optischen Achse an. Somit gibt p(h) diese Pfeilhöhe, d. h. den Abstand des Flächenpunktes vom Flächenscheitel in z-Richtung, d. h. in Richtung der optischen Achse. Die Konstanten K, A, B ... sind in Tabelle 1 wiedergegeben.

Die in den nachfolgenden Zeilen dargestellten Koeffizienten C0, C2, xde und yde beschreiben den Schichtdickenverlauf der bei einer bevorzugten Ausführungsform auf den jeweiligen Spiegeln aufgebrachten Reflexbeschichtungen gemäß der Formel in Gleichung (1), die bereits oben erläutert wurde. Hierbei gilt: $r_0= \sqrt{xde^2 + yde^2}$ .

Der Einfluss der gewählten Reflexbeschichtungen auf die Abbildungsqualität des Projektionsobjektives wird nun in verschiedenen Stufen erläutert.

Die rechnerische Konstruktion der Reflexbeschichtungen wurde unter der Randbedingung durchgeführt, dass jedes verwendete Schichtdesign die durchtretende Wellenfront nur insoweit stören darf, dass sich das Gesamtsystem nicht aus einem lokalen Minimum seiner Eigenschaften herausbewegt, welches bei Entwicklung des Grunddesigns mit unbeschichteten Substraten aufgefunden wurde. Dabei treten Wellenfrontfehler höherer Ordnung kaum auf, die wesentlichen Effekte sind Verzeichnung und Defokussierung. Qualitätskriterien für solche Schichtdesigns sind neben der Wellenfront (beispielsweise beschrieben durch Zernikekoeffizienten) und der Verzeichnung (in Scan-Richtung entsprechend y-Richtung) und in Cross-Scan-Richtung (entsprechend x-Richtung) die Felduniformität und die Pupillenapodisierung. Konstruktionstechnische und fertigungstechnische Systemeigenschaften bleiben gegenüber dem Grunddesign mit unbeschichteten Substraten nahezu unverändert.

Zunächst wird ein Projektionsobjektiv erläutert, bei dem alle Reflexbeschichtungen eine konstante Schichtdicke haben. Hierzu wird zweckmäßig aus den Winkelbelastungsberechnungen für jeden Spiegel ein Mittelwert für die mittleren Einfallswinkel auf den jeweiligen Spiegel berechnet, wozu der mittlere Einfallswinkel über den gesamten Nutzbereich des Spiegels gemittelt wird. Auf Grundlage dieses globalen, mittleren Einfallswinkels wird dann eine zugehörige optimale Schichtdicke bestimmt und in an sich bekannter Weise ein entsprechendes Schichtdesign erstellt.

Der wesentliche Effekt der gleichförmig dicken Schichten besteht in einem konstanten Bildversatz in Scan-Richtung bei einer deutlichen Defokussierung. Diese Fehler erster Ordnung können durch Reoptimierung wieder korrigiert werden. Bei der Wellenfrontaberration, gekennzeichnet durch den rms-Wert, ergab sich gegenüber unbeschichteten Designs eine Verschlechterung um ca. 20%.

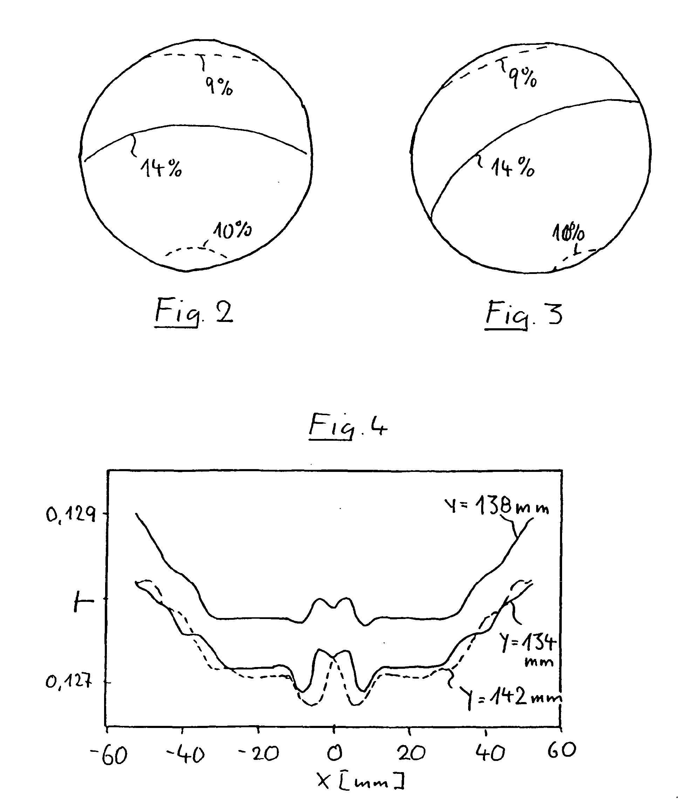

In den Fig. 2 und 3 sind die Intensitätsverteilungen in der kreisrunden Austrittspupille des Projektionsobjektiv für zwei Feldpunkte schematisch dargestellt, wobei Fig. 2 diese Verteilung für einen auf der Symmetrieachse des Systems liegende Feldpunkt zeigt und Fig. 3 die Verteilung für einen Feldpunkt am Rande des Ringfeldes darstellt. Die angegebenen Prozentangaben bezeichnen Bruchteile der am Eintritt des Projektionsobjektives vorliegenden Lichtintensität. Entsprechend der Rotationssymmetrie des Systems und der Beschichtungen (diese sind aufgrund konstanter Schichtdicke um jede zur optischen Achse parallele Achse rotationssymmetrisch) unterscheiden sich die beiden Intensitätsverteilungen nur durch eine Drehung um die Achse der Austrittspupille. Der Drehwinkel ergibt sich aus der Lage des Feldpunktes in der Objekt- oder Bildebene.

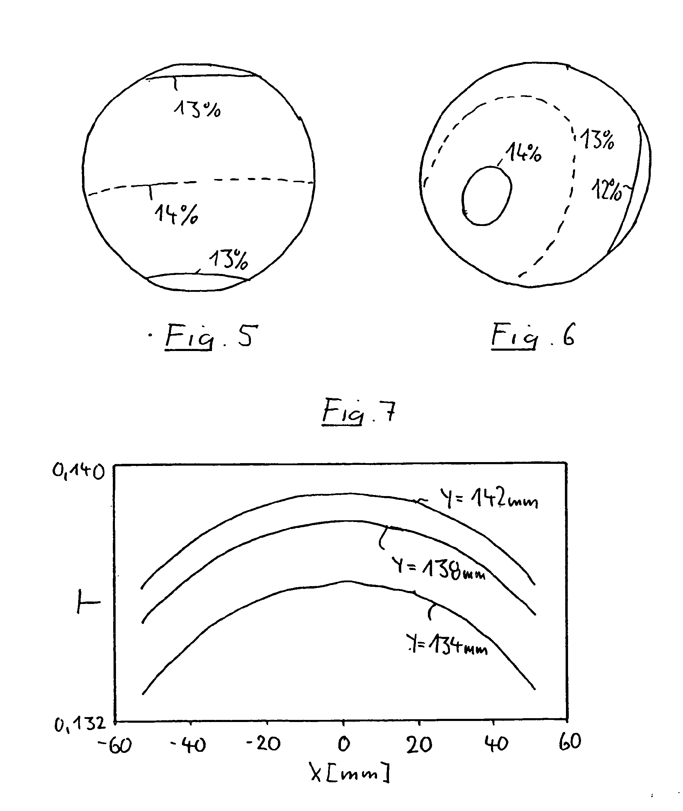

Die schematische Darstellung zeigt, dass eine starke Pupillenapodisierung auftritt. Die Intensität variiert zwischen ca. 3% und 14% über die Pupille. Die Bereiche verschiedener Werte für die Pupillenintensität sind anhand Linien gleicher Intensität in Fig. 2 und 3 dargestellt. Die spezielle Form der Verteilung mit einem außerhalb der Austrittspupille liegenden Zentrum würde eine große Differenz zwischen den kritischen Dimensionen (CD-Werten) für horizontale und vertikale Strukturen (h-v-Differenz) hervorrufen. Fig. 4 zeigt schematisch die Transmissionsverteilung über das Feld. Während die Variation in Scan-Richtung (entsprechend der y-Werte des Diagramms) durch die integrierende Wirkung des Scan-Vorgangs keinen wesentlichen negativen Einfluß ausübt, ist die Ungleichförmigkeit senkrecht zur Scan-Richtung, d.h. in cross-Scan-Richtung oder x-Richtung, für CD-Variationen über das Feld verantwortlich. Bei Gewichtung der Lichtverteilung mit der Lichtverteilung im Retikel kann dennoch eine dynamische Uniformity im Bereich von ca. 1% erreicht werden, was für viele Anwendungen ausreichend sein kann. Die durchschnittliche Transmission im gezeigten Beispiel beträgt ca. 13%, was im Hinblick auf die einfachen Reflexbeschichtungen ein sehr hoher Wert ist.

Bei dem in Fig. 1 gezeigten Design ist der bildfeldnahe fünfte Spiegel 8 derjenige Spiegel, an dem die größte Variation des mittleren Einfallswinkels über die genutzte Spiegelfläche auftritt. Als Inzidenzwinkel wird der jenige Winkel zwischen der Einfallsrichtung der ankommenden Strahlung und der Oberflächennormalen der reflektierenden Fläche im Auftreffpunkt der Strahlung bezeichnet. Die Inzidenzwinkelwerte liegen im Beispiel zwischen ca. 1° und 17°. Wird dieser Spiegel mit Schichten konstanter Dicke versehen, führt dies zu einem relativ hohen Reflektivitätsverlust.

Ein günstiger Kompromiss zwischen hoher Reflektivität und akzeptabler Wellenfrontkorrektur ist dadurch möglich, dass zumindest dieser Spiegel 8 mit einer gradierten, rotationssymmetrischen Reflexbeschichtung belegt wird, deren Schichtdickenverlauf gemäß Gleichung (1) beschreibbar sein kann.

Es hat sich gezeigt, dass es zu einer deutlichen Verbesserung der Reflektivität ausreichend sein kann, den Schichtverlauf auf der Symmetrieachse an die mittleren Einfallswinkel anzupassen.

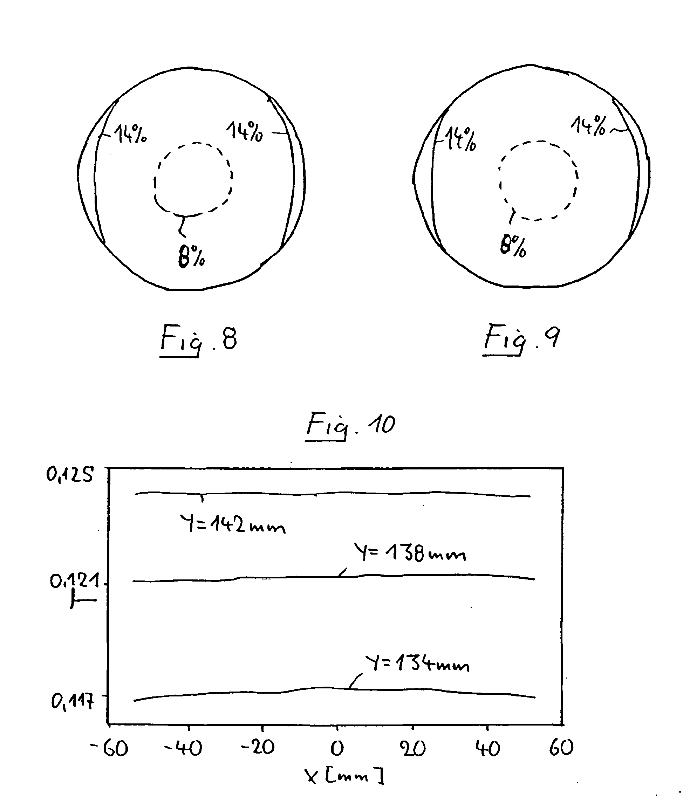

Dies ist in der Regel ein linearer Verlauf. Er kann mit dem in Gleichung (1) angegebenen Polynomansatz gut angepasst werden, wenn eine entsprechende Dezentrierung ($r_0$ ungleich 0) zugelassen wird. Die Abbildungen 5 und 6 der Intensitätsverteilungen in der Austrittspupille zeigen schematisch eine hohe durchschnittlicheTransmission von beispielsweise 13,7%, deren Schwankungsbreite zwischen ca 12% und ca. 14% liegt und damit deutlich geringer ist als beim oben beschriebenen Schichtsystem konstanter Schichtdicke. Allerdings ist die in Fig. 7 schematisch dargestellte Felduniformität mit ca. 2,5% etwas schlechter als bei konstanten Schichtdicken. Derartige Schichtsysteme mit lateralem Verlauf sind allerdings aufgrund einer relativ starken Verzeichnung in cross-Scan-Richtung (x-Richtung) nur in Ausnahmefällen geeignet, weil für diese Verzeichnung kein Kompensationseffekt durch den ScanVorgang wirkt.

Es konnte gezeigt werden, dass diese Verzeichnung im cross-Scan-Richtung im wesentlichen auf der Dezentrierung der gradierten Reflexschicht des fünften Spiegels 8 beruht. Entsprechend kann dieser Effekt verringert werden, wenn die Dezentrierung klein gehalten wird oder die gradierte Reflexschicht rotationssymmetrisch zur optischen Achse angeordnet wird. Typische optische Eigenschaften eines Designs mit zentrierter, gradierter Reflexschicht auf dem fünften Spiegel sind in den Fig. 8 bis 10 gezeigt. Es ist erkennbar, dass die Pupillenapodisierung mit ca. 8% im Bereich der Achse und ca. 14% im Rand der Pupille relativ groß ist. Allerdings ist sie rotationssymmetrisch zur Pupillenachse und damit auch unabhängig vom Feldpunkt. Hieraus ergibt sich dann auch unmittelbar die in Fig. 10 gezeigte, nahezu perfekte Uniformität (<0,4%) über das Feld. Die Gesamttransmission ist im Vergleich zu dem vorliegenden Design mit ca. 12% geringer.

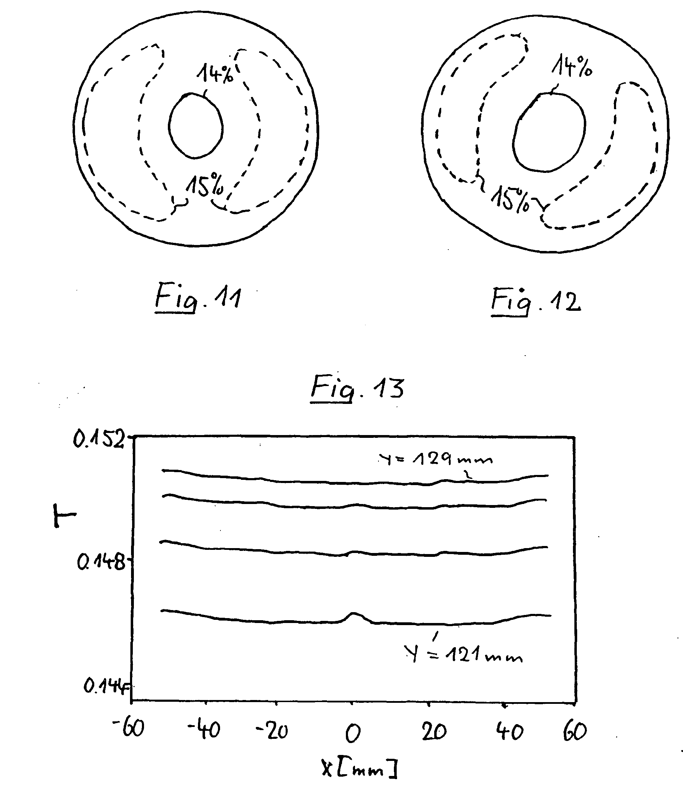

An Hand der Fig. 11 bis 13 wird nun eine Variante beschrieben, die im Hinblick auf eine rotationssymmetrische Pupillenapodisierung optimiert ist. Bei dieser Ausführung sind an zwei Spiegeln jeweils zentrierte, gradierte Reflexbeschichtungen aufgebracht, nämlich auf dem fünften Spiegel 8, an dem der größte Insidenzwinkelbereich auftritt, sowie an dem dem Lichtweg davor angeordneten dritten Spiegel 6. Die zentrierten Schichtverläufe dieser Spiegel sind so aufeinander abgestimmt, dass die Pupillenapodisierung, ähnlich wie beim Ausführungsbeispiel gemäß Fig. 8 bis 10, im wesentlichen rotationssymmetrisch ist. Im Unterschied zu dieser Ausführungsform besitzt jedoch die Pupillenapodisierung eine geringere Absolutwertvariation über die Austrittspupille, wobei die Gleichmäßigkeit der Ausleuchtung deutlich besser ist als bei nur einer zentrierten, gradierten Reflexbeschichtung. Wie an hand der Fig. 11 bis 13 zu erkennen ist, liegt die Intensitätsvariation in der Austrittspupille nur zwischen ca. 13,4% und ca. 15,6%, ist also deutlich geringer als die entsprechende Variation bei einer Ausführungsform mit nur einer zentrierten, gradierten Reflexbeschichtung (Fig. 8 bis 10). Zudem ist die Gesamttransmission mit ca. 14,7% im Vergleich zu dieser Ausführungsform deutlich größer und die Felduniformität mit Werten < 0,4% nahezu perfekt (Fig. 13). Die rotationssymmetrische Austrittspupille wird durch eine gezielte Abstimmung der Schichtdickenverläufe am dritten und fünften Spiegel erreicht. Das Beispiel zeigt, dass durch mehrere, zentrierte, gradierte Reflexbeschichtungen, deren Schichtdickenverläufe geeignet aufeinander abgestimmt sind, Pupillenhomogenität mit im wesentlichen rotationssymmetrischen Verlauf erzielbar sind.

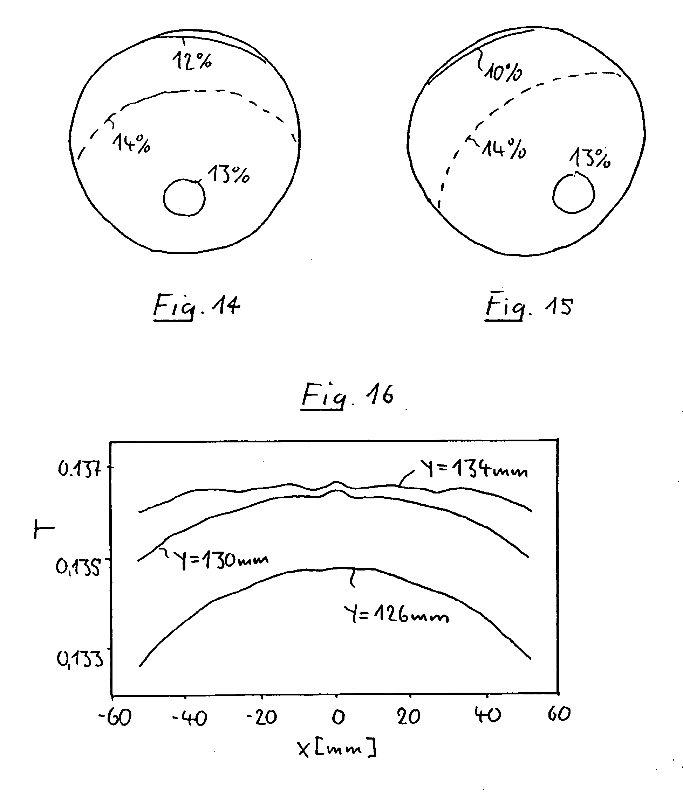

Anhand der Fig. 14 bis 16 wird nun eine Variante beschrieben, die einen vorteilhaften Kompromiss zwischen Gesamttransmission und Felduniformität ermöglicht. Um die oben erwähnte, durch dezentrierte Schichtsysteme induzierte Verzeichnung in cross-Scan-Richtung zu korrigieren, ist vorzugsweise vorgesehen, die Schichtverläufe von mehreren, d.h. von mindestens zwei Spiegeln zu dezentrieren und die einzelnen Dezentrierungen so aufeinander abzustimmen, dass sich die Verzeichnungsbeiträge teilweise oder vollständig kompensieren. Die Fig. 14 bis 16 zeigen die Eigenschaften eines Designs, bei dem neben den fünften Spiegel 8 auch der dritte Spiegel 6 eine dezentrierte, gradierte Reflexbeschichtung aufweist. Neben der Korrektur der cross-Scan-Verzeichnung (typische Werte unterhalb 1nm) und einer akzeptablen Wellenfrontkorrektur mit typischen Werten rms<30m$\lambda$ zeigt das System eine sehr hohe Gesamttransmission von ca. 13,6% und die in Fig. 16 schematisch dargestellte Felduniformität ist mit ca. 1,6% statischer Felduniformität akzeptabel. Der durch die Scan-Bewegung integrierte Wert dürfte im Bereich von 1% oder darunter liegen und damit noch deutlich günstiger sein. In den Figuren 14 und 15 ist zu erkennen, dass durch diese Beschichtungen ein Verlauf der Intensitätsverteilung in der Pupille erzeugt wird, der etwas ungünstiger ist als bei zentrierten, gradierten Beschichtung (Fig. 8 und 9). Die Schwankungsbreite liegt zwischen ca. 9% bis 14%. Jedoch ist die Apodisierung nicht vollständig oder rotationssymmetrisch, was sich nachteilig auf die Telezentrie und die Prozeßfenster auswirken kann.

Dem Fachmann ist nach der Erläuterung der der Erfindung zugrundeliegenden Grundprinzipien ersichtlich, dass die Verwendung geeignet angebracht und gegebenenfalls kombinierter, dezentrierter, gradierter Reflexbeschichtungen bei Projektionsobjektiven für die EUV-Mikrolithographie Projektionsobjektive konstruierbar sind, die einen guten Kompromiss zwischen Gesamttransmission und Felduniformität ermöglichen. Besonders günstig sind hierfür Designs mit mehreren, dezentrierten, gradierten Reflexbeschichtungen, da durch geeignete Relativanordnungen der Beschichtungen nachteilige Effekte auf Bildfehler wie Verzeichnung bei weitgehendem Erhalt der guten Gesamttransmission kompensiert werden können. Bei Bedarf können nicht tolerierbare Restfehler noch beseitigt werden, indem weitere, gradierte, dezentrierte Reflexbeschichtungen verwendet werden. Beispielsweise kann auf dem ersten Spiegel ein dezentriertes Grading angebracht sein, um die in Fig. 14 und 15 erkennbare Dezentrierung in der Pupille zu minimieren, ohne die Gesamttransmission wesentlich zu verringern.

Tabelle 1

| Fläche | Objekt | M1 | M2 | M3 | M4 | M5 | M6 | Bild |
|---|---|---|---|---|---|---|---|---|
| Radius | | -10704.6665 | 1058.26338 | 355.429333 | 565.293287 | 549.218427 | 535.96002 | |
| Abstand | 763.156811 | -508.895688 | 592.994217 | -263.021453 | 857.514737 | .437.185791 | 481.268511 | |
| K | | 0.129826 | -0.000242 | 0.000328 | 0.799355 | 0.000227 | 0.000006 | |
| A | | 5.01967E-10 | -8.68517E-11 | -8.94789E-10 | -6.05680E.10 | 5.28599E-09 | 6.69253E-11 | |
| B | | -3.60955E-15 | -8.37923E-16 | 1.08954E-14 | -1.14820E-15 | 1.32773E-13 | 3.07601E-16 | |
| C | | 4.75929E.20 | -7.38983E-21 | -1.55248E.18 | -3.64576E-20 | -2.91744E-18 | 1.31588E-21 | |
| D | | -1.15371E-24 | -2.2667SE-25 | 1.19824E-22 | 2.50168E.25 | 6.32401E-22 | 1.28668E-27 | |
| E | | 2.35510E-29 | -8.68225E-30 | -3.89134E.27 | -1.67219E-30 | -6.82763E-26 | 7.45365E-32 | |
| C0 | | 1.005E+00 | 1.007E+00 | 1.577E+00 | 1.010E+00 | 1.035E+00 | 1.002E+00 | |
| C2 | | 0.000E+00 | 0.000E+00 | -5.062E-08 | 0.000E+00 | -6.996E-06 | 0.000E+00 | |
| xde | | 0 | 0 | 0 | 0 | 0 | 0 | |
| yde | | 0 | 0 | 3159.89 | 0 | 14.5538 | 0 | |

EP 1 282 011 B1

**Patentansprüche**

1. Projektionsobjektiv zur Abbildung eines in einer Objektebene angeordneten Musters in eine Bildebene mit Hilfe von elektromagnetischer Strahlung aus dem extremen Ultraviolettbereich (EUV), wobei zwischen der Objektebene und der Bildebene mehrere mit Reflexbeschichtungen versehene, abbildende Spiegel angeordnet sind, die eine optische Achse des Projektionsobjektivs definieren, wobei mindestens einer der Spiegel eine gradierte Reflexbeschichtung mit einem zu einer Beschichtungsachse rotationssymmetrischen Schichtdickenverlauf aufweist, **dadurch gekennzeichnet, daß** die gradierte Reflexbeschichtung eine dezentrierte, gradierte Reflexbeschichtung ist, wobei die Beschichtungsachse exzentrisch zur optischen Achse des Projektionsobjektivs angeordnet ist.

2. Projektionsobjektiv nach Anspruch 1, bei dem die Spiegel derart ausgebildet und in Bezug zueinander angeordnet sind, dass jeder Spiegel aus einem für den Spiegel charakteristischen Inzidenzwinkelbereich bestrahlbar ist, wobei zumindest der Spiegel mit dem größten Inzidenzwinkelbereich eine dezentrierte, gradierte Reflexbeschichtung aufweist, wobei vorzugsweise die Inzidenzwinkel des Spiegels mit dem größten Inzidenzwinkelbereich in einen Bereich von weniger als 5° bis mehr als 10° liegen.

3. Projektionsobjektiv nach Anspruch 1 oder 2, bei dem einer der Spiegel eine erste dezentrierte, gradierte Reflexbeschichtung und mindestens ein anderer Spiegel eine zweite, dezentrierte, gradierte Reflexbeschichtung aufweist, wobei die erste und die zweite dezentrierte, gradierte Reflexbeschichtung derart aufeinander abgestimmt sind, dass sich Beiträge der Reflexbeschichtungen zu Bildfehlern, insbesondere zur Verzeichnung, mindestens teilweise kompensieren, wobei vorzugsweise die dezentrierten, gradierten Reflexbeschichtungen derart relativ zueinander angeordnet sind, dass sich Beiträge der Reflexbeschichtungen zur Verzeichnung in einer senkrecht zu einer Scan-Richtung verlaufenden cross-Scan-Richtung gegenseitig kompensieren.

4. Projektionsobjektiv nach einem der vorhergehenden Ansprüche, bei dem eine Scan-Richtung und eine senkrecht dazu ausgerichtete cross-Scan-Richtung definiert ist und bei dem mindestens eine dezentrierte, gradierte Reflexbeschichtung in Scan-Richtung dezentriert ist.

5. Projektionsobjektiv nach einem der vorhergesehenden Ansprüche, bei dem zwischen Objektebene und Bildebene mehr als fünf Spiegel insbesondere sechs Spiegel, vorgesehen sind.

6. Projektionsobjektiv nach einem der vorhergesehenden Ansprüche, bei dem alle Spiegel koaxial zueinander angeordnet sind.

7. Projektionsobjektiv nach einem der vorhergesehenden Ansprüche, bei dem zumindest der fünfte auf die Objektebene folgende Spiegel eine dezentrierte, gradierte Reflexbeschichtung aufweist, wobei vorzugsweise der vierte und der fünfte auf die Objektebene folgende Spiegel oder der dritte und der fünfte auf die Objektebene folgende Spiegel eine dezentrierte, gradierte Reflexbeschichtung aufweist.

8. Projektionsobjektiv nach einem der vorhergesehenden Ansprüche, bei dem die dezentrierte, gradierte Reflexbeschichtung einen rotationssymmetrischen Schichtdickenverlauf der Schichtdicke (d) hat, der wie folgt beschreibbar ist:

$$d = d_0 \sum_{i=0}^{n} c_{2i} (r - r_0)^{2i}$$

wobei $d_0$ eine für senkrechten Strahlungseinfall optimierte Schichtdicke, $r_0$ eine Dezentrierung, r eine Radialkoordinate in x-y-Ebene und c ein Koeffizient ist.

9. Projektionsobjektiv nach einem der vorhersehenden Ansprüche bei dem das Projektionsobjektiv eine bildseitige numerische Apertur DNA$\geq$0,15, insbesondere von NA$\geq$0,2 hat.

10. Projektionsobjektiv nach einem der vorhersehenden Ansprüche bei dem die Spiegel derart ausgebildet und angeordnet sind, dass zwischen Objektebene und Bildebene ein Zwischenbild erzeugt wird.

11. Projektionsobjektiv nach einem der Ansprüche 1 oder 3 bis 10, wobei die Spiegel derart ausgebildet und in Bezug zueinander angeordnet sind, dass jeder Spiegel aus einem für den Spiegel charakteristischen Inzidenzwinkelbereich bestrahlbar ist, wobei zumindest der Spiegel mit dem größten Inzidenzwinkelbereich eine gradierte Reflexbeschichtung mit einem zu einer Beschichtungsachse rotationssymmetrischen Schichtdickenverlauf aufweist und wobei die Beschichtungsachse im wesentlichen mit der optischen Achse des Projektionsobjektivs zusammenfällt.

12. Projektionsobjektiv nach Anspruch 11, bei dem der Schichtdickenverlauf der gradierten Reflexbeschichtung zur Erzeugung einer im wesentlichen rotationssymmetrischen Pupillenhomogenität optimiert ist, wobei vorzugsweise mehrere, vorzugsweise maximal vier, Spiegel mit zentrierten, gradierten Reflexionsbeschichtungen vorgesehen sind, wobei die Schichtdickenverläufe der Reflexionsbeschichtungen derart aufeinander abgestimmt sind, dass eine im wesentlichen rotationssymmetrische Pupillenhomogenität vorliegt.

## Claims

1. Projection objective for imaging a pattern arranged in an object plane into an image plane with the aid of electromagnetic radiation from the extreme ultraviolet range (EUV), a plurality of imaging mirrors provided with reflection coatings being arranged between the object plane and the image plane and defining an optical axis of the projection objective, at least one of the mirrors having a graded reflection coating with a layer thickness profile that is rotationally symmetrical with respect to a coating axis, **characterized in that** the graded reflection coating is a decentred graded reflection coating, the coating axis being arranged eccentrically with respect to the optical axis of the projection objective.

2. Projection objective according to Claim 1, wherein the mirrors are formed and arranged in relation to one another in such a way that each mirror can be irradiated from an angle of incidence range that is characteristic of the mirror, at least the mirror with the largest angle of incidence range having a decentred graded reflection coating, the angles of incidence of the mirror with the largest angle of incidence range preferably lying within a range of less than 5° to more than 10°.

3. Projection objective according to Claim 1 or 2, wherein one of the mirrors has a first decentred graded reflection coating and at least one other mirror has a second decentred graded reflection coating, the first and the second decentred graded reflection coating being coordinated with one another in such a way that contributions of the reflection coatings to image aberrations, in particular to distortion, at least partially compensate for one another, the decentred graded reflection coatings preferably being arranged relative to one another in such a way that contributions of the reflection coatings to distortion in a cross scan direction running perpendicular to a scan direction mutually compensate for one another.

4. Projection objective according to one of the preceding claims, wherein a scan direction and a cross scan direction oriented perpendicular thereto are defined, and wherein at least one decentred graded reflection coating is decentred in the scan direction.

5. Projection objective according to one of the preceding claims, wherein more than five mirrors, in particular six mirrors, are provided between the object plane and the image plane.

6. Projection objective according to one of the preceding claims, wherein all the mirrors are arranged coaxially with respect to one another.

7. Projection objective according to one of the preceding claims, wherein at least the fifth mirror following the object plane has a decentred graded reflection coating, preferably the fourth and the fifth mirror following the object plane or the third and the fifth mirror following the object plane having a decentred graded reflection coating.

8. Projection objective according to one of the preceding claims, wherein the decentred graded reflection coating has a rotationally symmetrical layer thickness profile of the layer thickness (d) which can be described as follows:

$$d = d_0 \sum_{i=0}^{n} c_{2i} (r = r_0)^{2i}$$

where $d_0$ is a layer thickness optimized for perpendicular radiation incidence, $r_0$ is a decentring, r is a radial coordinate in the x-y plane and c is a coefficient.

9. Projection objective according to one of the preceding claims, wherein the projection lens has an image-side numerical aperture of NA≥0.15, in particular of NA≥0.2.

10. Projection objective according to one of the preceding claims, wherein the mirrors are formed and arranged in such a way that an intermediate image is generated between the object plane and the image plane.

11. Projection objective according to one of Claims 1 or 3 to 10, the mirrors being formed and arranged in relation to one another in such a way that each mirror can be irradiated from an angle of incidence range that is characteristic of the mirror, at least the mirror with the largest angle of incidence range having a graded reflection coating with a layer thickness profile that is rotationally symmetrical with respect to a coating axis, and the coating axis essentially coinciding with the optical axis of the projection lens.

12. Projection objective according to Claim 11, wherein the layer thickness profile of the graded reflection coating is optimized for generating an essentially rotationally symmetrical pupil homogeneity, preferably a plurality of mirrors, preferably a maximum of four mirrors, with centred graded reflection coatings being provided, the layer thickness profiles of the reflection coatings being coordinated with one another in such a way that an essentially rotationally symmetrical pupil homogeneity is present.

## Revendications

1. Objectif de projection destiné à représenter dans un plan d'image un modèle disposé dans un plan d'objet à l'aide d'un rayonnement électromagnétique de la plage ultraviolette extrême (EUV), plusieurs miroirs de représentation munis de revêtements réfléchissants étant disposés entre le plan d'objet et le plan d'image, lesquels définissent un axe optique de l'objectif de projection, au moins l'un des miroirs présentant un revêtement réfléchissant gradué avec un tracé d'épaisseur de couche à symétrie rotationnelle par rapport à un axe de revêtement, **caractérisé en ce que** le revêtement réfléchissant gradué est un revêtement réfléchissant gradué décentré, l'axe du revêtement étant disposé de manière excentrique par rapport à l'axe optique de l'objectif de projection.

2. Objectif de projection selon la revendication 1, avec lequel les miroirs sont configurés et disposés les uns par rapport aux autres de telle sorte que chaque miroir peut être exposé aux rayons à partir d'une plage d'angles d'incidence caractéristique pour le miroir, au moins le miroir ayant la plage d'angles d'incidence la plus grande présentant un revêtement réfléchissant gradué décentré, l'angle d'incidence du miroir ayant la plage d'angles d'incidence la plus grande se trouvant de préférence dans une plage entre moins de 5° et plus de 10°.

3. Objectif de projection selon la revendication 1 ou 2, avec lequel l'un des miroirs présente un premier revêtement réfléchissant gradué décentré et au moins l'un des autres miroirs présente un deuxième revêtement réfléchissant gradué décentré, le premier et le deuxième revêtements réfléchissants gradués décentrés étant accordés l'un sur l'autre de telle sorte que les contributions des revêtements réfléchissants aux aberrations d'image, notamment à la distorsion d'image, sont au moins partiellement compensées, les revêtements réfléchissants gradués décentrés étant de préférence disposés l'un par rapport à l'autre de telle sorte que les contributions des revêtements réfléchissants à la distorsion d'image dans une direction de balayage transversale qui s'étend perpendiculairement à une direction de balayage sont compensées.

4. Objectif de projection selon l'une des revendications précédentes, avec lequel sont définies une direction de balayage et une direction de balayage dirigée perpendiculairement à celle-ci et avec lequel au moins un revêtement réfléchissant gradué décentré est décentré dans la direction du balayage.

5. Objectif de projection selon l'une des revendications précédentes, avec lequel plus de cinq miroirs, notamment six miroirs sont prévus entre le plan d'objet et le plan d'image.

6. Objectif de projection selon l'une des revendications précédentes, avec lequel tous les miroirs sont disposés de manière coaxiale les uns par rapport aux autres.

7. Objectif de projection selon l'une des revendications précédentes, avec lequel au moins le cinquième miroir suivant le plan d'objet présente un revêtement réfléchissant gradué décentré, de préférence le quatrième et le cinquième miroir suivant le plan d'objet ou le troisième et le cinquième miroir suivant le plan d'objet présentant un revêtement réfléchissant gradué décentré.

**8.** Objectif de projection selon l'une des revendications précédentes, avec lequel le revêtement réfléchissant gradué décentré possède un tracé d'épaisseur de couche à symétrie rotationnelle de l'épaisseur de couche (d) qui peut être décrit comme suit :

$$d = d_0 \sum_{i=0}^{n} c_{2i}(r - r_0)^{2i}$$

où $d_0$ est une épaisseur de couche optimisée pour l'incidence perpendiculaire des rayons, $r_0$ un décentrage, r une coordonnée radiale dans un plan x-y et c un coefficient.

**9.** Objectif de projection selon l'une des revendications précédentes, avec lequel l'objectif de projection possède une ouverture numérique côté image NA $\geq$ 0,15, notamment NA $\geq$ 0,2.

**10.** Objectif de projection selon l'une des revendications précédentes, avec lequel les miroirs sont configurés et disposés de telle sorte qu'une image intermédiaire est générée entre le plan d'objet et le plan d'image.

**11.** Objectif de projection selon l'une des revendications 1 ou 3 à 10, les miroirs étant configurés et disposés les uns par rapport aux autres de telle sorte que chaque miroir peut être exposé aux rayons à partir d'une plage d'angles d'incidence caractéristique pour le miroir, au moins le miroir ayant la plage d'angles d'incidence la plus grande présentant un revêtement réfléchissant gradué avec un tracé d'épaisseur de couche à symétrie rotationnelle par rapport à un axe de revêtement et l'axe de revêtement coïncidant pour l'essentiel avec l'axe optique de l'objectif de projection.

**12.** Objectif de projection selon la revendication 11, avec lequel le tracé d'épaisseur de couche du revêtement réfléchissant gradué étant optimisé pour produire une homogénéité de pupille essentiellement à symétrie rotationnelle, de préférence plusieurs, de préférence un maximum de quatre miroirs munis de revêtements réfléchissants gradués centrés étant prévus, les tracés d'épaisseur de couche des revêtements réfléchissants étant accordés les uns sur les autres de telle sorte qu'une homogénéité de pupille essentiellement à symétrie rotationnelle est obtenue.

_Fig. 1_

EP 1 282 011 B1

Fig. 2

Fig. 3

Fig. 4

13%

14%

13%

·Fig. 5

14%   13%

12%

Fig. 6

Fig. 7

0,140

Y = 142mm

Y = 138mm

Y = 134mm

⊢

0,132

-60   -40   -20   0   20   40   60

X [mm]

Fig. 8

Fig. 9

Fig. 10

X [mm]

Fig. 11

Fig. 12

Fig. 13

*Fig. 14*

*Fig. 15*

*Fig. 16*